# EUROPÄISCHE PATENTSCHRIFT

(11) **EP 0 993 677 B1**
(45) Veröffentlichungstag und Bekanntmachung des Hinweises auf die Patenterteilung: **06.03.2002**
(21) Anmeldenummer: 98936221.5
(22) Anmeldetag: 18.06.1998
(51) Int. Cl.: H01H 37/76, H01H 37/00

(54) **THERMOSICHERUNG ZUR FIXIERUNG AUF EINEM SCHALTUNGSSUBSTRAT**
THERMAL RELEASE FOR FIXING ON A CIRCUIT SUBSTRATE
PROTECTION THERMIQUE POUR LA FIXATION SUR UN SUBSTRAT DE COMMUTATION

(30) Priorität: 02.07.1997 DE 19728255
(43) Veröffentlichungstag der Anmeldung: 19.04.2000
(73) Patentinhaber: Tyco Electronics Logistics AG, 9323 Steinach / SG (CH)
(72) Erfinder: BÜHREND, Matthias, D-81539 München (DE); TEMPLIN, Frank, D-10367 Berlin (DE)
(74) Vertreter: Klunker . Schmitt-Nilson . Hirsch
(86) Internationale Anmeldenummer: DE9801678
(87) Internationale Veröffentlichungsnummer: WO9901879

(56) Entgegenhaltungen:
- EP-A- 0 228 200
- WO-A-93/26028
- GB-A- 635 223
- US-A- 3 529 272
- US-A- 4 885 560

## Beschreibung

Die Erfindung betrifft eine Thermosicherung zur Fixierung auf einem Schaltungssubstrat.

Derartige Sicherungen dienen zum Schutz von Schaltungsteilen vor thermischer Überlastung, insbesondere durch Stoßspannungen, und können bei beliebigen Schaltungen, zum Beispiel auf Leiterplatten, eingesetzt werden. Bevorzugtes Anwendungsgebiet der erfindungsgemäßen Thermosicherung sind jedoch Schichtschaltungen, insbesondere Dickschicht-Hybridschaltungen, wie sie beispielsweise in der Telekommunikation Verwendung finden.

Eine Thermosicherung der eingangs genannten Art ist beispielsweise aus der DE 42 19 554 A1 bekannt. Bei der dort beschriebenen Sicherung handelt es sich um eine Bügelsicherung, die an zwei Lötpunkten befestigt ist. Die Thermosicherung ist mit einem definierten Dickschicht-Widerstand im Keramiksubstrat elektrisch in Reihe geschaltet. Bei angelegter Spannung erwärmt der durchfließende Strom über die Widerstandsschicht die Keramik, die durch geschickt gewählte hot spots mindestens eine der beiden Lötstellen der Sicherung thermisch belastet und bei Stromüberlastung aufweicht. Die bekannte Bügelsicherung muß nach dem Auflöten zunächst mechanisch vorgespannt werden, so daß im Überlastungsfall ein Federbügel von der aufgeweichten Lötstelle wegschnellt und somit die elektrische Verbindung unterbricht.

Eine Bügelsicherung, die aktiviert wurde, kann nicht ohne weiteres in den Ausgangszustand rückgestellt bzw. ausgetauscht werden. Problematisch bei dem bekannten Sicherungstyp ist außerdem, daß der Aufweichprozeß des Lotes und damit einhergehend das Freiwerden des Federbügels bzw. die Unterbrechung des Stroms ein relativ langsamer und wenig abrupter Prozeß ist.

Der Erfindung liegt daher die Aufgabe zugrunde, eine Thermosicherung der eingangs genannten Art zu schaffen, die einerseits relativ universell bei verschiedenen Schaltungen einsetzbar ist, die andererseits aber nach einer Aktivierung mit möglichst geringem Aufwand wieder rückstellbar ist und die außerdem ein schnelles und abruptes Auslöseverhalten aufweisen soll, das im Störfall eine ordentliche Stromunterbrechung gewährleistet.

Diese Aufgabe wird bei einer Thermosicherung der eingangs genannten Art erfindungsgemäß dadurch gelöst,
- daß ein flächiges Thermobimetall-Schnappelement vorgesehen ist,
- das mit hochschmelzendem Lot durch mindestens eine Lötstelle auf dem Schaltungssubstrat befestigt und das mit dem Schaltungssubstrat thermisch gekoppelt ist,
- wobei die Lötstelle als erste Kontaktstelle zur Verbindung mit einem entsprechenden Schaltungskontakt des Schaltungssubstrats ausgebildet ist,
- und daß das Schnappelement buckelförmig derart mechanisch vorgewölbt ist, daß es bei nicht aktivierter Sicherung eine zweite Kontaktstelle des Schaltungssubstrats elektrisch leitend berührt, bei ausgelöster Sicherung und damit umgekehrter Buckelwölbung jedoch nicht.

Vorteilhafte Ausgestaltungen des Gegenstandes der Erfindung sind in den Unteransprüchen angegeben.

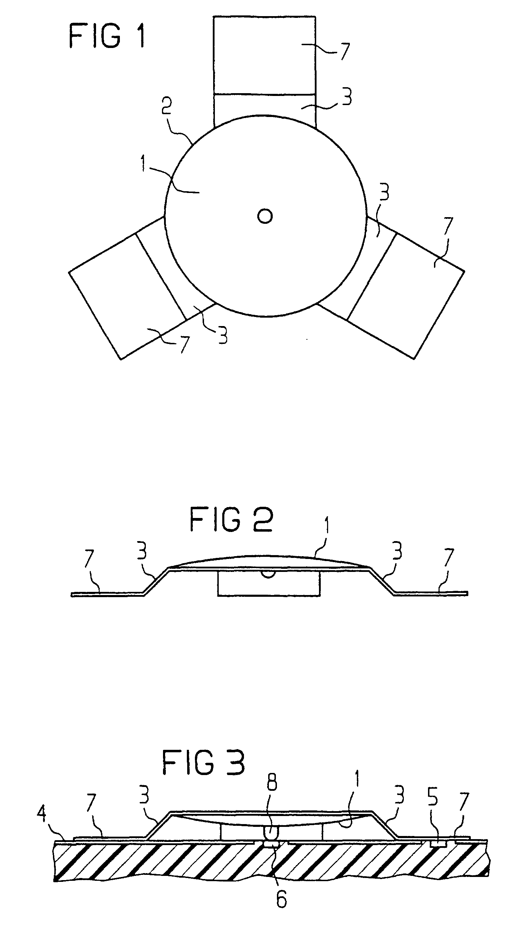

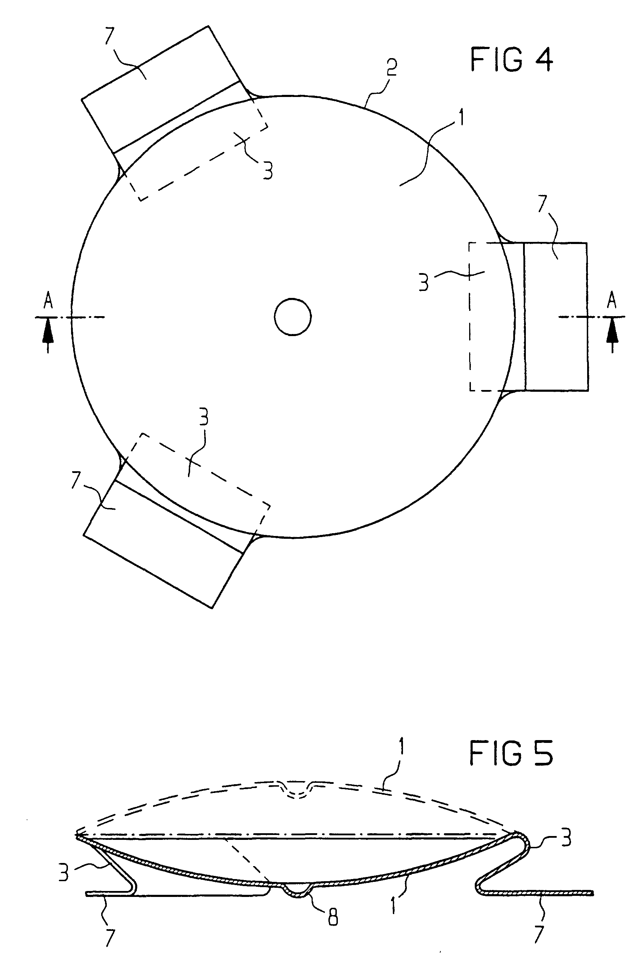

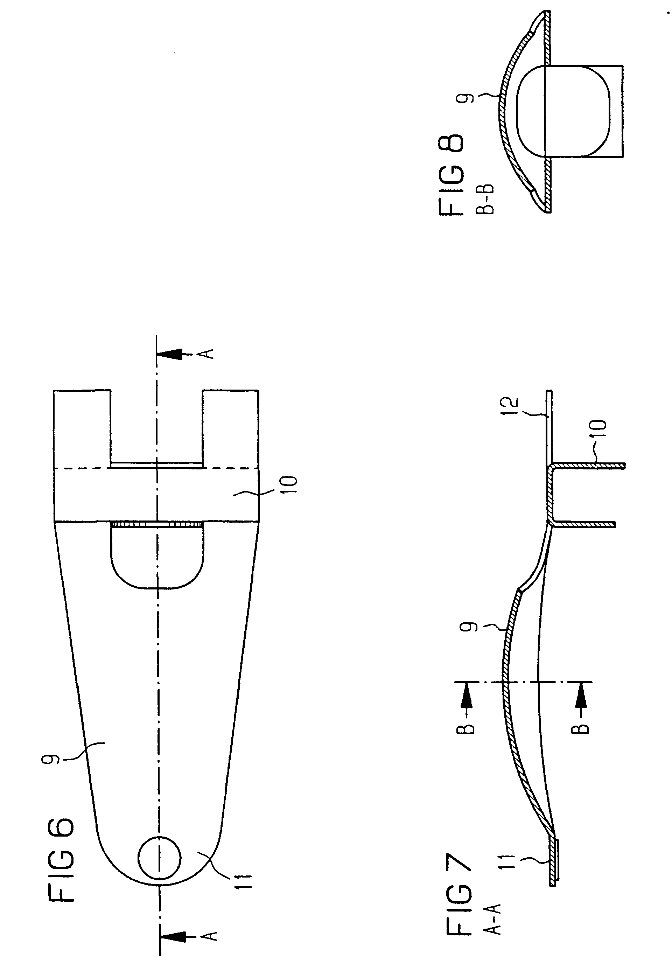

Die Erfindung und ihre Weiterbildungen werden im folgenden, insbesondere anhand von in der Zeichnung dargestellten Ausführungsbeispielen erläutert. Es zeigen
- Figur 1 - 5: zwei Ausführungsbeispiele einer ersten Ausführungsform der Erfindung, wobei Figur 1 eine Draufsicht und Figur 2 und 3 jeweils eine Seitenansicht eines Ausführungsbeispiels im aktivierten (Figur 2) bzw. nicht aktivierten (Figur 3) Zustand der Sicherung zeigt, und Figur 4 und 5 in analoger Darstellung ein zweites Ausführungsbeispiel der ersten Ausführungsform,

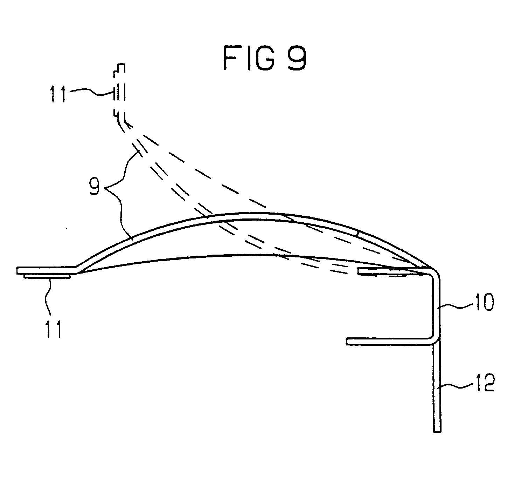

- Figur 6 - 9: eine zweite Ausführungsform der Erfindung, wobei Figur 6 eine Draufsicht, Figur 9 eine Seitenansicht und Figur 7 und 8 jeweils einen Schnitt einer nicht aktivierten Sicherung, wobei in Figur 9 auch der aktivierte Zustand angedeutet ist, zeigen.

Die Erfindung beruht auf einem diskontinuierlich arbeitenden Thermobimetall-Schnappelement, das mit hochschmelzendem Lot auf dem Schaltungssubstrat befestigt ist.

Bei einer ersten Ausführungsform ist eine Thermobimetall-Schnappscheibe 1 vorgesehen, an deren Wölbungsrand 2 drei metallische Standbeine 3 angeordnet sind, deren Enden jeweils mit hochschmelzendem Lot in Form einer Lötstelle auf dem Schaltungssubstrat 4 (vgl. Figur 3) befestigt sind, wobei eine der drei Lötstellen als erste Kontaktstelle 5 zur Verbindung mit einem entsprechenden Schaltungskontakt des Schaltungssubstrats 4 ausgebildet ist. Außerdem ist die Schnappscheibe 1 schüsselförmig derart nach unten zum Schaltungssubstrat 4 hin mechanisch vorgewölbt, daß bei nicht ausgelöster Sicherung eine elektrische Verbindung von dem mit der ersten Kontaktstelle 5 verlöteten ersten Standbein 3 zu einer zweiten Kontaktstelle 6 des Schaltungssubstrats 4, auf der die Scheibenmitte aufliegt, besteht.

Bei Nichtaktivierung der Sicherung wird also die elektrische Verbindung zwischen den beiden Kontaktstellen 5, 6 eines der Standbeine 3 und der Scheibenmitte, die in diesem Zustand auf einem Schaltungskontakt aufliegt, hergestellt. Die an sich bekannte Eigenschaft der Formänderung eines Bimetalls bei Erwärmung aufgrund der unterschiedlichen thermischen Ausdehnungkoeffizienten der beiden enthaltenen Metalle wird bei der Erfindung in abgewandelter, spezifischer Weise ausgenutzt. Die Schnappscheibe 1 ist unterhalb des Arbeitstemperaturbereiches mechanisch angenähert in Form einer Schüssel oder eines Buckels vorgewölbt, vgl. Figuren 3 und 5. Dadurch wird eine Diskontinuität der Formänderung und ein selbsttätiger Rückstellmechanismus ermöglicht.

Bis zu einer bestimmten Temperatur (obere Schnapptemperatur) wird die Formänderung durch die Geometrie der Scheibe verhindert, oberhalb dieser Temperatur wird der Formänderung nachgegeben und die Wölbung, nachdem sich genügend Spannung aufgebaut hat, sehr schnell und abrupt in die andere Richtung umgekehrt, wodurch der elektrische Kontakt gelöst wird. Der thermische Kontakt mit dem Schaltungssubstrat 4, beispielsweise der Keramik, bleibt jedoch über insbesondere zwei der Standbeine 3 dadurch erhalten, daß sie in hot spots des Substrats 4 gelegt werden. Die Lötstellen des zweiten und dritten Standbeins 3 sind demnach auf dem Schaltungssubstrat 4 so angeordnet, daß sie in innigem Wärmekontakt mit thermisch belasteten Schaltungsteilen, insbesondere Schichtwiderständen, stehen. Kühlt das Schaltungssubstrat 4 nach der Stoßspannung wieder ab, stellt die Sicherung den elektrischen Kontakt bei einer unteren Schnapptemperatur durch erneutes Umklappen der Scheibenwölbung wieder her. Der Arbeitstemperaturbereich kann auf einfache Weise durch die geometrischen Abmessungen der Schnappscheibe 1 festgelegt werden.

Im Auslösefall der Sicherung erwärmt die Keramik über die Standbeine 3 die Schnappscheibe 1. Da diese eine relativ geringe Größe (Durchmesser ca. 1 cm) und Dicke (ca. 0,1 mm) aufweist, geschieht dies sehr schnell. Die Schnappscheibe 1 klappt um und löst den elektrischen Kontakt. Nach Abkühlung wird der elektrische Kontakt selbsttätig wieder hergestellt. Tritt im Extremfall eine sehr hohe Temperaturbelastung auf, lösen sich die zwei der thermischen Verbindung dienenden Standbeine 3, wodurch keine elektrische Verbindung nach Abkühlung wieder hergestellt werden kann. Vorteilhafterweise fällt die Thermosicherung auch in diesem Extremfall nicht von der Keramik, wie es von der Anwendungspraxis her gefordert wird.

Die in den Figuren 1 bis 5 erkennbaren Standbeine 3 liefern die notwendige Gegenkraft, damit sich die Schnappscheibe 1 aufgrund der inneren Spannungen vor- und zurückwölben kann; sie dürfen deshalb nicht zu labil ausgeführt sein. Aus Kostengründen bietet sich eine einstückige Verbindung der Standbeine 3 zur Schnappscheibe 1 an. Im Hinblick auf den Montagevorgang der Thermosicherung ist es von Vorteil, wenn - wie in allen Figuren dargestellt - die Enden der Standbeine 3 als in einer Ebene liegende, Lötanschlüsse bildende Kontaktlappen 7 ausgebildet sind. Auf diese Weise sind die Enden der Standbeine 3 für eine SMD-Montage- und Löttechnik geeignet ausgebildet, so daß auch mehrere Thermosicherungen gemeinsam in einem Arbeitsgang im Reflow-Verfahren gelötet werden können. Um einen sicheren Kontakt im nicht aktivierten Zustand der Sicherung zu gewährleisten, kann die nach unten zum Schaltungssubstrat 4 hin gewölbte Schnappscheibenmitte vorteilhaft mit einer Kontaktnase 8 mit Goldbeschichtung, beispielsweise durch Prägen, versehen werden.

Um die auf die Standbeine 3 wirkenden Kräfte abzufedern, insbesondere aber auch um einen Prelleffekt bei der selbsttätigen Rückstellung der Schnappscheibe 1 in den deaktivierten Zustand zu vermeiden, ist es vorteilhaft, die Standbeine 3 elastisch auszubilden. Dies kann beispielsweise in einer der beiden in den Figuren 2, 3 bzw. 5 dargestellten Weise geschehen. Die Ausführung gemäß Figur 5 ist dabei platzsparender als die gemäß Figur 2 bzw. 3. In den Figuren 2, 3 und 5 ist die Schnappscheibe 1 im übrigen auch im mittleren, ebenen Durchgangszustand zwischen den beiden Wölbungszuständen dargestellt. Die relative Kleinheit der Schnappscheibe 1 bedingt einen Schnappweg zwischen den beiden Wölbungszuständen von nur ca. 2 mm, was hinsichtlich der Einbauhöhe vorteilhaft ist. Das Schaltungssubstrat 4 als Ganzes einschließlich der erfindungsgemäßen Thermosicherungen kann gegebenenfalls selbst wieder oberflächenmontiert werden.

Eine zweite Ausführungsform der Erfindung ist in den Figuren 6 bis 9 dargestellt. Das als Halboval ausgelegte Schnappelement 9 mit einer buckel- bzw. bogenförmigen Wölbung, vgl. Figur 9, arbeitet bezüglich des Schnappeffekts in gleicher Weise wie zuvor am Beispiel der Schnappscheibe 1 beschrieben. Allerdings eignet sich diese Ausführungsform bevorzugt zum zwangfreien Aufstecken mittels des U-Elements 10 (Preßsitz) auf das Schaltungssubstrat und anschließendem Festlöten mit hochschmelzendem Lot. Die Lötstelle braucht beim Schalt- bzw. Umklappvorgang der Sicherung keine Scherkräfte abzufangen und auch die thermische Ankopplung an das Substrat ist auf diese Weise vorteilhaft gelöst. Der schmale, dem U-Element 10 gegenüberliegende Endbereich 11 des Schnappelements 9 wird durch den Umklappprozeß aus der in Figur 9 durchgezogen dargestellten Berührsituation, also dem nicht aktivierten Zustand, in die von der zweiten Kontaktstelle entfernt Position (umgekehrte Wölbung des Bogens) gebracht. Dargestellt ist auch ein im Schnappelement 9 integrierter SMD-Ansauggreifer 12.

## Patentansprüche

1. Thermosicherung zur Fixierung auf einem Schaltungssubstrat,
wobei
- ein flächiges Thermobimetall-Schnappelement (1, 9) vorgesehen ist,
- das mit hochschmelzendem Lot durch mindestens eine Lötstelle auf dem Schaltungssubstrat (4) befestigt und das mit dem Schaltungssubstrat (4) thermisch gekoppelt ist,
- wobei die Lötstelle als erste Kontaktstelle (5) zur Verbindung mit einem entsprechenden Schaltungskontakt des Schaltungssubstrats (4) ausgebildet ist,
- und wobei das Schnappelement (1, 9) buckelförmig derart mechanisch vorgewölbt ist, daß es bei nicht aktivierter Sicherung eine zweite Kontaktstelle (6) des Schaltungssubstrats (4) elektrisch leitend berührt, bei ausgelöster Sicherung und damit umgekehrter Buckelwölbung jedoch nicht.

2. Thermosicherung nach Anspruch 1,
**dadurch gekennzeichnet,**
**daß** eine Thermobimetall-Schnappscheibe (1) vorgesehen ist, an deren Wölbungsrand (2) drei metallische Standbeine (3) angeordnet sind, deren Enden jeweils mit hochschmelzendem Lot in Form einer Lötstelle auf dem Schaltungssubstrat (4) befestigt sind, wobei eine der drei Lötstellen als erste Kontaktstelle (5) zur Verbindung mit einem entsprechenden Schaltungskontakt des Schaltungssubstrats (4) ausgebildet ist, und **daß** die Schnappscheibe (1) schüsselförmig derart nach unten zum Schaltungssubstrat (4) hin mechanisch vorgewölbt ist, **daß** bei nicht aktivierter Sicherung eine elektrische Verbindung von dem mit der ersten Kontaktstelle (5) verlöteten ersten Standbein (3) zu einer zweiten Kontaktstelle (6) des Schaltungssubstrats (4), auf der die Scheibenmitte aufliegt, besteht.

3. Thermosicherung nach Anspruch 2,
**dadurch gekennzeichnet,**
**daß** die Lötstellen des zweiten und dritten Standbeins (3) auf dem Schaltungssubstrat (4) so angeordnet sind, **daß** sie in innigem Wärmekontakt mit thermisch belasteten Schaltungsteilen stehen.

4. Thermosicherung nach Anspruch 2 oder 3,
**dadurch gekennzeichnet,**
**daß** die Standbeine (3) elastisch ausgebildet sind.

5. Thermosicherung nach einem der Ansprüche 2 bis 4,
**dadurch gekennzeichnet,**
**daß** die Enden der Standbeine (3) als in einer Ebene liegende, Lötanschlüsse bildende Kontaktlappen (7) ausgebildet sind.

## Claims

1. A thermal release for fixing on a circuit substrate, in which
a planar thermal bimetallic snap-on element (1, 9) is provided
which is secured by at least one soldering point to the circuit substrate (4) using solder of a high melting point and is thermally coupled to the circuit substrate (4),
the soldering point being constructed as a first contact point (5) for connection to a corresponding circuit contact of the circuit substrate (4), and
the snap-on element (1, 9) being mechanically pre-curved into the shape of a boss such that it is in electrically conductive contact with a second contact point (6) of the circuit substrate (4) when the release is not activated, but is not when the release is triggered and thus the curvature of the boss is reversed.

2. A thermal release according to Claim 1, **characterised in that** a thermal bimetallic snap-on disc (1) is provided, at the curvature rim (2) whereof three metal feet (3) are arranged whereof the ends are each secured to the circuit substrate (4) using solder of a high melting point in the form of a soldering point, one of the three soldering points being constructed as a first contact point (5) for connection to a corresponding circuit contact of the circuit substrate (4), and **in that** the snap-on disc (1) is mechanically pre-curved downward towards the circuit substrate (4) into the shape of a dish, **in that** when the release is not activated there is an electrical connection between the first foot (3), soldered to the first contact point (5), and a second contact point (6) of the circuit substrate (4) on which the centre of the disc lies.

3. A thermal release according to Claim 2, **characterised in that** the soldering points of the second and third feet (3) are arranged on the circuit substrate (4) such that they are in intimate thermal contact with thermally loaded circuit parts.

4. A thermal release according to Claim 2 or 3, **characterised in that** the feet (3) are of resilient construction.

5. A thermal release according to one of Claims 2 to 4, **characterised in that** the ends of the feet (3) are constructed as contact lugs (7) lying in a plane and forming solder terminals.

## Revendications

1. Protecteur thermique destiné à être fixé sur un substrat de circuit,
comportant un élément d'enclenchement plan à bilame thermique (1, 9),
fixé avec de la soudure à point de fusion élevée par au moins un point de soudure sur le substrat de circuit (4) et couplé thermiquement au substrat de circuit (4),
le point de soudure formant le premier point de contact (5) en vue de la connexion avec un contact de commutation correspondant du substrat du circuit (4),
l'élément d'enclenchement (1, 9) étant incurvé d'avance de manière mécanique en forme de bombement, contactant de manière électro-conductrice un deuxième point de contact (6) du substrat de circuit (4) en cas de non activation du protecteur, mais ne le contactant pas lors du déclenchement du protecteur, l'incurvation bombée étant inversée.

2. Protecteur thermique selon la revendication 1, **caractérisé en ce qu'**il comporte un disque d'enclenchement à bilame thermique (1), sur le bord incurvé duquel (2) sont agencés trois pieds de support métalliques (3), dont les extrémités sont respectivement fixées par de la soudure à point de fusion élevé sous forme d'un point de soudure sur le substrat du circuit (4), un des trois points de soudure formant un premier point de contact (5) en vue de la connexion avec un contact de commutation correspondant du substrat du circuit (4), le disque d'enclenchement (1) étant incurvé d'avance de manière mécanique en forme de bol vers le bas en direction du substrat du circuit (4) de sorte à établir, lorsque le protecteur n'est pas activé, une connexion électrique du premier pied de support (3) fixé par soudage au premier point de contact (5) vers un deuxième point de contact (6) du substrat du circuit (4), sur lequel repose le centre du disque.

3. Protecteur thermique selon la revendication 2, **caractérisé en ce que** les points de soudure du deuxième et du troisième pied de support (3) sont agencés sur le substrat du circuit (4) de sorte à être en contact thermique étroit avec les éléments du circuit soumis à une charge thermique.

4. Protecteur thermique selon les revendications 2 ou 3, **caractérisé en ce que** les pieds de support (3) sont élastiques.

5. Protecteur thermique selon l'une des revendications 2 à 4, **caractérisé en ce que** les extrémités des pieds de support (3) ont la forme de pattes de contact (7) formant des raccordements de soudure, situés dans un plan.
